# EUROPEAN PATENT SPECIFICATION

(11) **EP 2 555 601 B1**
(45) Date of publication and mention of the grant of the patent: **02.01.2019**
(21) Application number: 11837769.6
(22) Date of filing: 22.02.2011
(51) Int. Cl.: H05K 3/18, C23C 18/16, C23C 18/20, C23C 18/30, C23C 18/38, C25D 3/38, H05K 1/02, H05K 3/00, H05K 3/38

(54) **METHOD OF PRODUCING FORMED CIRCUIT COMPONENT**
VERFAHREN ZUR HERSTELLUNG EINER GEFORMTEN SCHALTUNGSKOMPONENTE
PROCÉDÉ DE PRODUCTION D'UN COMPOSANT DE CIRCUIT À FORME

(30) Priority: 04.02.2011 JP 2011022554; 04.11.2010 JP 2010247029
(43) Date of publication of application: 06.02.2013
(73) Proprietor: Sankyo Kasei Co., Ltd., Tokyo146-0085 (JP)
(72) Inventor: YUMOTO, Tetsuo, Tokyo 146-0085 (JP); WATANABE, Mitsuhiro, Yokosuka-shi Kanagawa 239-0806 (JP); SAITO, Yuichi, Yokosuka-shi Kanagawa 239-0806 (JP)
(74) Representative: Schwabe - Sandmair - Marx
(86) International application number: PCT/JP2011/053789
(87) International publication number: WO 2012/060115

(56) References cited:
- EP-A1- 1 253 217
- WO-A2-90/00634
- JP-A- 2000 212 757
- JP-A- 2004 273 707
- JP-A- 2008 106 345
- US-A1- 2010 047 458
- US-B1- 6 286 207
- HEININGER ET AL: "Fertigung von MID Bauteilen vom Rapid Prototyping bis zur Serie mit innovativer LDS-Technologie", RICONE SYMPOSIUM, XX, XX, 1 October 2003 (2003-10-01), XP002395995,
- BEIL S ET AL: "Photochemical functionalization of polymer surfaces for subsequent metallization", SURFACE AND COATINGS TECHNOLOGY, vol. 116, 1999, pages 1195-1203, XP028609904, ISSN: 0257-8972, DOI: 10.1016/S0257-8972(99)00155-3
- WANG Z ET AL: "Polymer hydrophilicity and hydrophobicity induced by femtosecond laser direct irradiation", APPLIED PHYSICS LETTERS, A I P PUBLISHING LLC, US, vol. 95, no. 11, 17 September 2009 (2009-09-17), pages 111110-111110, XP012122033, ISSN: 0003-6951, DOI: 10.1063/1.3232212

## Description

### Technical Field

The present invention relates to a method for producing a formed circuit component, which includes steps of selectively roughening a surface of a synthetic resin by irradiating with a laser beam, and forming an electroless plating layer on the surface.

### Background Art

When an electroconductive circuit is formed by selectively providing an electroless plating on a surface of a base composed of a synthetic resin, it is necessary to roughen the surface of the base in advance so as to improve adhesiveness with the electroless plating. As a method for roughening the surface, chemical etching using hexavalent chromium sulfate is exemplified (for example, see Patent Document 1).

However, work environment is inferior since hexavalent chromium is toxic. Furthermore, in order to treat used drainage water of an etchant safely, it is necessary to reduce the hexavalent chromium to trivalent chromium, and thereafter to precipitate the trivalent chromium by neutralization, and thus very cumbersome treatments are required. Therefore, hexavalent chromium sulfate is designated as a substance whose use for products is prohibited in view of environments. Furthermore, in order to selectively roughen the surface of a base by chemical etching, a labor hour to cover a surface to be not roughened with a mask is necessitated. Alternatively, in the case when the entire surface of a base is roughened in advance by chemical etching, in order to provide a catalyst and electroless plating to only a circuit forming portion, that is a portion to be formed into a circuit, a labor hour to cover a non-circuit forming portion, that is a portion to be not formed into a circuit with a mask is necessitated. Moreover, since the non-circuit forming portion is also roughen, a surface of the non-circuit forming portion becomes hydrophilic, whereby insulating property is significantly decreased under a high humidity environment, and decoration of the roughened non-circuit forming portion is necessitated in some cases.

Therefore, a means for ensuring adhesiveness of an electroless plating formed on a surface of a circuit forming portion by selectively irradiating the surface of a base composed of a synthetic resin with a laser beam or the like and then roughening only circuit forming portion is proposed (for example, see Patent Documents 2 and 3). Namely, the paragraph "0024" and FIG. 6 and the like of Patent Document 2 describe a method including irradiating only a film forming area of a base 1 with an ultraviolet laser to roughen the area, attaching nuclei thereto, removing a nucleating agent on an area that has not been roughened by washing or the like, and thereafter conducting electroless plating to precipitate and form a plated film only on the film forming area.

Furthermore, the paragraphs "0088" to "0089" and FIG. 11 of Patent Document 3 describe a method including irradiating a circuit pattern forming portion of an insulating substrate 1 with an ArF excimer laser to roughen the portion, attaching palladium 3 thereto, irradiating again the substrate except the circuit pattern forming portion with a laser, and washing the substrate to remove palladium 3a on a portion other than the circuit pattern forming portion, and forming an electroless copper plating 5 only on the circuit pattern forming portion.

Patent Document 4 discloses a resin structure including a resin layer and a metal layer. The resin layer is formed of a single material. The metal layer is laminated directly on the resin layer without intervention of an adhesive layer between the resin layer and the metal layer. A surface of the resin layer, on which the metal layer is laminated, has a surface roughness of a value in a range of 0.1 microns to microns, as a rough surface . The rough surface is obtained by performing wet blasting on a selected portion of one surface of the resin substrate . The metal layer is formed on the rough surface of the resin layer.

Prior art document "Fertigung von MID Bauteilen vom Rapid Prototyping bis zur Serie mit innovativer LDS-Technologie", Heininger et al., Ricone Symposium, 1 October 2003 (2003-10-01) discloses a layer direct structuring process for molded interconnect devices. The process is based on doted thermoplastic materials on which the tracks that are to be realized are activated by means of targeting laser radiation and then metalized in a chemical bath. The compound used for doting the materials are metal organic complexes. By irradiation, these compounds are decomposed into a metal atom and several organic parts . The metal atom is thereafter used as a catalyzer for copper deposition onto the parts which were irradiated by laser.
The publication BEIL S ET AL: "Photochemical functionalization of polymer surfaces for subsequent metallization" SURFACE AND COATINGS TECHNOLOGY, vol. 116, pages 1195-1203, XP028609904, ISSN: 0257-8972, DOI: 10.1016/S0257-8972 (99) 00155-3 discloses the use of laser irradiation for the formation of polar functional groups on a surface of a polymer. The resulting functional groups allow for a spontaneous deposition of molecular thin films from aqueous solutions. These can be complexes from noble metals. The deposited noble metal complexes can be converted in a reducing step to generate a metallic layer on the surface (palladium) which is catalytically active for electroless metal deposition.

The document WANG Z ET AL: "Polymer hydrophilicity and hydrophobicity induced by femtosecond laser direct irradiation", APPLIED PHYSICAS LETTERS, A I P PUBLISHING LLC, US, vol. 95, no. 11, 17 September 2009 (2009-09-17), pages 111110-111110, XP012122033, ISSN: 0003-6951, DOI: 10.1063/1.3232212 discloses the use of a femtosecond laser having a wavelength of 775 nm to modify the polymer surface wettability.

### Prior Art Documents

### Patent Documents

Patent Document 1: Japanese Patent Application Laid-Open (JP-A) No. 10-335781
Patent Document 2: JP-A No. 07-116870
Patent Document 3: JP-A No. 07-212008
Patent Document 4: US 6,286,207 B1

### Summary of the Invention

### Problem to be Solved by the Invention

Meanwhile, in order to selectively form an electroless plating layer only on a circuit forming portion, it is necessary to be continued on original page 4 to prevent formation of an electroless plating on a non-circuit forming portion wherein the portion has not been roughened by a laser. However, it has been proved that the methods described in the above-mentioned Patent Documents 2 and 3 have a problem that is still to be improved in this regard.

Namely, in the above-mentioned Patent Document 2, as mentioned above, the paragraph "0024" therein describes that "only the area for forming a film of the base 1 is roughened with an ultraviolet laser, nuclei are attached thereto, a nucleating agent on an area to be not roughened is removed by washing or the like, and thereafter electroless plating is conducted, whereby a plated film is precipitated and formed only on the area for forming a film". However, the nucleating agent is difficult to be removed by washing or the like in some cases, even though the nucleating agent is attached to the non-film forming area that has not been irradiated with laser and thus has not been roughened, depending on the kind and the surface state of the base, or in the case when a filler is included in the base, and in such cases, an electroless plating is precipitated on the residual catalyst nucleating agent.

Since an electroless plating precipitated on the non-film forming area that has not been roughened as mentioned above has low adhesiveness with the base, the plating is peeled off from the base in the next step of electroless plating and falls into a plating bath, which leads to deterioration of a plating liquid. Furthermore, when the residue of the electroless plating remains on the unroughened portion, the insulating property between circuits is impaired.

Furthermore, as mentioned above, the paragraphs "0088" to "0089" of the above-mentioned Patent Document 3 describe "palladium on the portion other than the circuit pattern forming area, i.e. , the portion that has not been roughened with a laser, is removed by irradiation of a laser and washing, and electroless plating is performed to form an electroless copper plating 5 only on the circuit pattern forming portion". Thus, if the attached palladium is removed by irradiating a laser by doing so, formation of an electroless plating on the portion from which palladium has been removed can be avoided. However, in such method a labor hour to irradiate lasers repetitively is necessary so as to remove the palladium attached to the non-circuit forming portion. Furthermore, since the non-circuit forming portion is also roughened during removal of palladium by irradiating the portion with the laser, the insulating property between the electroconductive circuits is decreased and decoration of the non-plated surface is necessitated in some cases as mentioned above.

Therefore, the object of the present invention is to provide a method for producing a formed circuit component, in which an electroless plating can be prevented from precipitating on a non-circuit forming portion wherein the portion has not been roughened by a laser beam.

### Means for Solving the Problem

The present inventors have done intensive studies so as to solve the above-mentioned problem, and found that catalyst nuclei that remain on a non-circuit forming portion wherein the portion has not been roughened by a laser beam, can be decreased if the catalyst nuclei are formed by providing an ion catalyst composed of one kind of metal ion such as palladium and reducing the catalyst, whereby formation of an electroless plating layer on the non-circuit forming portion can be readily avoided, and completed the present invention.

Meanwhile, although the reason why the catalyst nuclei that remain on the non-circuit forming portion wherein the portion has not been roughened are decreased when the catalyst nuclei are formed by imparting an ion catalyst and reducing the catalyst is not understood clearly at this time, it is generally presumed as follows. Namely, the circuit forming portion wherein the portion has been irradiated with a laser beam is surface-modified and roughened. To be specific, the molecular chains on the surface layer of the base are cut by the laser beam, and active oxygen atoms that are generated by the contact of the laser beam with air are bound to the molecules whose molecular chains have been cut, whereby functional groups that are rich in oxygen including an OH group, a COH group, a COOH group or the like are formed. Furthermore, since the surface layer of the base has been roughened by the laser beam, the above-mentioned functional groups are formed inside of the roughened fine concave structures. Here, it is considered that the ion catalyst is adsorbed on the base by electrically attracting with the functional groups one another. Therefore, the ion catalyst is tightly adsorbed by electrically attracting with the functional groups one another in the inner area of this roughened fine concave structures. Furthermore, since hydrophilicity is imparted to the surface that has been modified with the laser beam, the ion catalyst attaches easily and readily penetrates into the layer of the modified layer.

On the other hand, since the non-circuit forming portion wherein the portion has not been irradiated with the laser beam is not surface-modified and roughened, the above-mentioned functional groups are not formed thereon, and roughened fine concave structures are also not formed. Therefore, it is presumed that the ion catalyst does not attach to the non-circuit forming portion wherein the portion has not been roughened and on which functional groups are not formed.

Meanwhile, both the above-mentioned Patent Documents 2 and 3 only describe about the catalyst for electroless plating that "nuclei are attached to the base", and do not describe that "the ion catalyst is reduced by a reducing agent" about the attachment of nuclei. Therefore, it is considered that the methods described in the documents do not utilize, as a catalyst, an ion catalyst but utilize "a sensitizing-activator method" or "a catalyst-accelerator method" in which tin and palladium form colloids. Therefore, it is considered that these colloidal catalysts are attached to the surface of a synthetic resin by the effect of tin that surrounds palladium. Therefore, depending on the kind and surface state of the synthetic resin, or in the cases when a filler is mixed, and the like, the palladium catalyst is also adsorbed by the affinity of tin on the non-circuit' forming portion wherein the portion has not been roughened, whereby a plating becomes easy to precipitate on a portion that has not been irradiated with a laser.

In addition, it was confirmed from the result of the comparative test mentioned below that the catalyst is not adsorbed on a non-roughened surface and an electroless plating is not precipitated when an ion catalyst is used, whereas a part of the catalyst is adsorbed on the non-roughened surface and a part of the electroless plating is precipitated when a colloidal catalyst is used.

Therefore, the method for the producing a formed circuit component according to the present invention is characterized by including a first step of forming a base of a synthetic resin, a second step of irradiating a circuit forming portion of the base with a laser beam having a wavelength of from 405 to 1,064 nm to selectively roughen and surface-modify the portion, a third step of contacting the base with an ion catalyst composed of one kind of metal ion, a fourth step of reducing the ion catalyst to a metal by a reducing agent, and a fifth step of forming an electroless plating layer on the circuit forming portion of the base.

As used herein, the "synthetic resin" is preferably a thermoplastic resin, or may be a thermosetting resin, and examples of such resin include aromatic-based liquid crystal polymers, polyether ether ketones, polysulfones, polyether polysulfones, polyarylsulfones, polyetherimides, polyesters, acrylonitrile-butadiene-styrene copolymer resins, polyamides, modified polyphenyleneoxide resins, norbornene resins, phenol resins and epoxy resins. Preferably, an aromatic-based polyamide selected from a group consisting of 10T nylon, 9T nylon, 6T nylon, 4T nylon and polyphthalamide (PPA) that includes a filler selected from a group consisting of titanium oxide, potassium titanate, zinc oxide, talc, glass fibers, calcium pyrophosphate and alumina oxide is used.

The "base" means an element on which surface an electroconductive circuit can be formed, and the shape thereof is not limited. For example, the base includes film-like one, planar one, polygonal block-shaped one, one having a curved surface, and rod-like one, and also includes one composed of a plurality of parts. Furthermore, the base is not limited to the case when the base itself is composed of an insulating material, and also includes one having an electroconductive element whose surface is covered with an insulating material.

The "laser beam having a wavelength of from 405 to 1,064 nm" is selected so as to modify the surface of the base and roughen the surface of the base to a state coarser than 1 µm to ensure adhesiveness with the electroless plating layer. Namely, an ultraviolet laser having a wavelength of 248 nm is used as an Example in the above-mentioned Patent Document 2 and the like, but a laser having such short wavelength has high light energy and is suitable for surface-modifying a synthetic resin but is not suitable for heat melting and sublimating the surface of the synthetic resin to increase a degree of roughness. On the other hand, when the wavelength of the laser increases, the laser is suitable for melting and sublimating the surface of the synthetic resin to increase a degree of roughness, but has low light energy and thus is not suitable for the surface-modifying the synthetic resin. Therefore, by adjusting the wavelength of the laser beam to from 405 to 1,064 nm, a property of midway between a laser beam having a short wavelength and a laser beam having a long wavelength, i.e., the surface of the base can be modified, and the surface of the base can be roughened to a state coarser than 1 µm.

The "ion catalyst composed of one kind of metal ion" means a solution of one kind of metal ion selected from a group of palladium, copper and the like. Namely, in the conventional "sensitizing-activator method" and "catalyst-accelerator method" for electroless plating, tin and palladium form colloids during addition of a catalyst in both methods, whereas the "ion catalyst composed of one kind of metal ion" is completely different since tin is not included and the ion of any palladium, copper and the like does not form colloids. Meanwhile, "contacting with the ion catalyst" is not limited to the case when the base is soaked in an aqueous solution including palladium ion and the like, and also includes the case when an aqueous solution including palladium ion and the like is sprayed or the like on the base.

That "the ion catalyst is reduced to a metal by a reducing agent" is an essential condition so that the ion catalyst attached to the base is reduced to a metal to form metal nuclei for precipitating a metal for electroless plating. For example, sodium borohydrate, dimethylamineborane, hydrazine, sodium hypophosphite and formaldehyde corresponds to the "reducing agent" used herein, and is desirably an aqueous solution having a content rate of from 0.01 to 100 g/liter. Meanwhile, the content rate is more desirably from 0.5 to 30 g/liter, and further desirably from 1.0 to 10 g/liter. This is because when the content rate is lower than 0.01 g/liter, the time for reducing the ion catalyst is extended, whereas when the content rate exceeds 100 g/liter, the time for reducing the ion catalyst is changed little and thus use of excess reducing agent is wasted.

For example, an electroless copper plating layer, an electroless nickel plating layer and an electroless gold plating layer correspond to the "electroless plating layer", and a case in which an electroless plating layer composed of other plating metal is deposited on the surface of one electroless plating layer is also included.

The above-mentioned ion catalyst is desirably one obtained by diluting the ion concentration to from 10 to 180 ppm by using an acidic aqueous solution such as an aqueous solution of hydrochloric acid or sulfuric acid (pH 1.5 to 2.5) or an alkaline aqueous solution such as an aqueous solution of caustic soda or caustic potash (pH 10 to 11). Furthermore, one obtained by diluting the ion concentration to from 10 to 100 ppm is more desirable . This is because when the ion concentration is diluted, the ion catalyst is more difficult to attach to the unroughened surface of the non-circuit forming portion wherein the portion has not been irradiated with the laser beam, whereby an electroless plating becomes hard to precipitate on the non-circuit forming portion. Furthermore, by diluting the ion concentration, resource saving of precious metals such as palladium can be ensured. The reason why the ion concentration is adjusted to from 10 to 180 ppm is that, when the ion concentration is lower than 10 ppm, the time for forming an electroless plating layer having a predetermined thickness on the circuit forming portion wherein the portion has been roughened by irradiation of the laser beam, is extended, whereas when the ion concentration exceeds 180 ppm, an electroless plating precipitates easily on the non-circuit forming portion.

Furthermore, it is more desirable to include a sixth step of removing the residue of the electroless plating formed during the initial stage of the precipitation reaction on the non-circuit forming portion of the above-mentioned base by using a reagent. This is because the electroless plating formed during the initial stage of the precipitation reaction on the non-circuit forming portion can be removed more definitely. As the reagent, for example, and an aqueous solution of a persulfate salt, an aqueous solution of nitric acid and an aqueous solution of sulfuric acid hydrogen peroxide, and a ferric chloride liquid, a cupric chloride liquid and the like that are used for etching of circuits and the like, can be used.

Furthermore, the above-mentioned selectively roughened surface desirably has an average roughness of at least 1 µm. By doing so, an anchoring effect can be improved, whereby adhesiveness with the electroless plating layer can be enhanced more.

It is desirable to provide a second metal layer to the surface of the electroless plating layer of the above-mentioned circuit forming portion. An electroless plating having a different plating metal from that of the above-mentioned electroless plating layer, or an electroplating corresponds to the "second metal layer" used herein. By laminating an electroless plating having a different plating metal on the first electroless plating layer, the durability, heat-resistance and the like of the plating layer can be improved, or by depositing an electroplating, a thick plating layer can be formed rapidly.

### Effect of the Invention

The non-circuit forming portion is not roughened since the portion has not been irradiated with a laser beam. Therefore, hydrophobicity can be kept, and the insulating property between circuits can be ensured even under high humidity environment. Furthermore, decoration is not necessitated. By irradiating the circuit forming portion with a laser beam having a wavelength of from 405 to 1,064 nm, the surface layer of the circuit forming portion can be modified and roughened to the extent that an anchoring effect can be exerted sufficiently, whereby the adhesiveness between the circuit forming portion and the electroless plating layer can be ensured.

Furthermore, by using an ion catalyst of one kind of metal, adsorption of the catalyst nuclei on the unroughened non-circuit forming portion wherein the portion has not been irradiated with a laser beam can be avoided, whereby formation of an electroless plating layer on the non-circuit forming portion can be avoided. Moreover, by diluting the ion catalyst, an electroless plating can further be difficult to precipitate on the unroughened non-circuit forming portion wherein the portion has not been irradiated with a laser beam, and resource saving of precious metals such as palladium can be ensured.

In addition, by removing the residue of the electroless plating formed during the initial stage of the precipitation reaction remaining on the non-circuit forming portion of the base by a reagent, even if the residue of the electroless plating is generated, the residue can be removed certainly. Furthermore, by roughening the circuit forming portion by irradiating with a laser beam so as to have an average roughness of at least 1 µm, the anchoring effect can be improved, whereby adhesiveness with the electroless plating layer can further be enhanced. In addition, by providing the second metal layer to the surface of the electroless plating layer of the circuit forming portion, the durability, heat-resistance and the like of the plating layer can be improved, or a thick plating layer can be formed rapidly.

### Brief Description of the Drawings

FIG. 1 is a process chart that shows a method for producing a formed circuit component; and
FIG. 2 is other process chart that shows a method for producing a formed circuit component.

### Reference Signs List

1, 101 base
11, 111 circuit forming portion
12, 112 non-circuit forming portion
2, 102 laser beam
3, 103 electroless copper plating layer (electroless plating layer)
104 electro copper plating layer (second metal layer)

### Best Mode for Carrying out the Invention

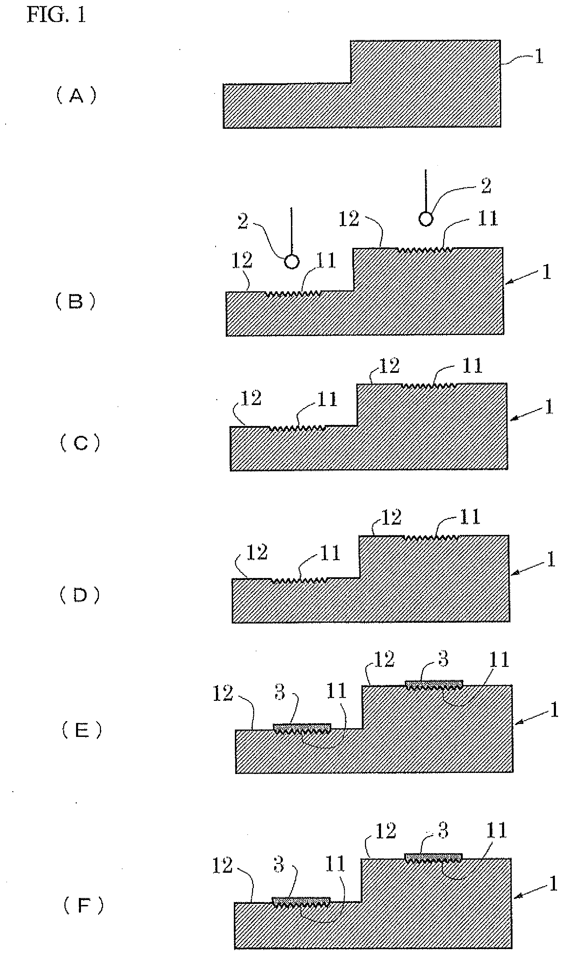

An example of the method for producing a formed circuit component according to the present invention is explained with referring to FIG. 1. As shown in FIG. 1, the method for producing a formed circuit component according to the present invention includes the first to sixth steps ((FIG. A) to (FIG. F)). In the first step (FIG. A), an aromatic-based polyamide (6T nylon) (for example, "#NM114HW", a product of Otsuka Chemical Co. , Ltd.) in which titanium oxide and potassium titanate whiskers have been mixed as fillers is injection-molded to form a block-shaped base 1.

Next, in the second step (FIG. B), a circuit forming portion 11 of the base 1 is irradiated with a laser beam 2 to modify and roughen the surface. As the laser beam 2, a second higher harmonic wave having a wavelength of 532 nm is used, and scanning is performed only one time after adjusting the output to 95% of 6 W, the scan speed by a galvanometer mirror to 500 mm/second and the pulse frequency to 40 KHz. In addition, by this irradiation with the laser beam 2, functional groups are generated on the circuit forming portion 11, and the surface is roughened to the degree of roughness of 80 µm level by a ten-point average.

Next, although it is not depicted, the base 1 is washed with an alkali and further activate the surface so that the catalyst is easily adsorbed on the roughened surface . The alkali washing is performed by, for example, soaking the base 1 for 5 minutes in an aqueous solution of sodium hydroxide having a concentration of 50 g/liter and a temperature of 50°C. Next, the activation is performed by, for example, soaking the base 1 for 5 minutes in an aqueous solution that is obtained by diluting a surfactant (for example, "PB-119S", a product of Ebara-Udylite Co., Ltd.) to 50 cc/liter and setting the temperature to 25°C.

In the third step (FIG. C), the above-mentioned activated base 1 is soaked for 2 minutes in an ion catalyst liquid that is obtained by diluting a palladium ion catalyst (for example, "#ACT-S", a product of Ebara-Udylite Co., Ltd.) to an ion concentration of 50 ppm by an aqueous solution (pH 2.0) of hydrochloric acid having a concentration of 0.06% and setting the temperature to 25°C, whereby the palladium ion catalyst is adsorbed on the circuit forming portion 11 wherein the portion has been irradiated with the laser beam 2. Meanwhile, the above-mentioned activated base 1 may be soaked for 5 minutes after diluting a palladium ion catalyst ("#Neogant 834", a product of Atotech Japan K. K.) to an ion concentration of 50 ppm by, for example, an aqueous solution of caustic soda (pH 10.5) and setting the temperature to 40°C. Since the circuit forming portion 11 wherein the portion has been irradiated with the laser beam 2 has been surface-modified and functional groups have been formed thereon as mentioned above, the palladium ion catalyst enters into the modified layer and reacts with the functional groups and is tightly fixed in the modified layer. However, the palladium ion catalyst is not adsorbed on a non-circuit forming portion 12 wherein the portion has not been roughened by the laser beam.

Next, in the fourth step (FIG. D), the base 1 is soaked in an aqueous solution of sodium borohydrate having a temperature of 25°C and a concentration of 1.5 g/liter, whereby the adsorbed palladium ion catalyst is reduced to palladium metal. As mentioned above, since the palladium ion catalyst is fixed tightly in the modified layer that has been surface-modified by irradiating with the laser beam 2, the reduced palladium metal is also tightly adsorbed in the modified layer. However, since the palladium ion catalyst is not adsorbed on the non-circuit forming portion 12 wherein the portion has not been roughened by the laser beam, the palladium metal is not fixed on the non-circuit forming portion. In addition, although not depicted here, a step of soaking the base 1 on which the palladium metal has been adsorbed in the above-mentioned aqueous solution of a surfactant may also be included. This aims at activating the surface of the adsorbed palladium metal by removing the oxide layer and the like to promote precipitation of the next electroless plating layer.

Next, in the fifth step (FIG. E), the base 1 is soaked in an electroless copper plating liquid to precipitate a copper metal by using the palladiummetal as nuclei that has been tightly fixed in the modified layer, whereby an electroless copper plating layer 3 is formed on the circuit forming portion 11. For example, the base 1 is soaked for about 15 minutes in an electroless copper plating liquid (for example, "AISL-520", a product of Ebara-Udylite Co., Ltd.) whose liquid temperature has been set to 50°C. By doing so, the electroless copper plating layer 3 having a thickness of from 0.5 to 0.6 µ is formed.

In the case when the residue of the electroless copper plating formed during the initial stage of the precipitation reaction remains on the non-circuit forming portion 12, by soaking the base 1 for around 20 seconds in an aqueous solution of persulfuric acid having a concentration of 10 g/liter, whose temperature has been set to 40°C, as the sixth step (FIG. F), the remaining residue of the electroless copper plating can be removed certainly.

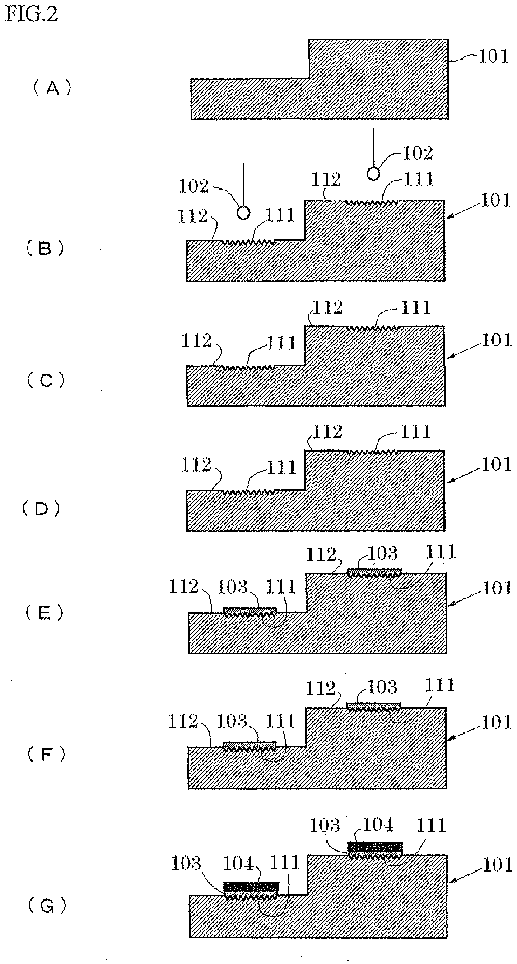

With referring to FIG. 2, the other method for producing a formed circuit component according to the present invention is explained. The steps (A) to (F) of this method shown in FIG. 2 are similar to the steps (A) to (F) that are shown in the above-mentioned FIG. 1, but FIG. 2 is different in that the final step (G) has been added. For convenience of reference and the like, the portions and sites in FIG. 2 that are similar to those shown in FIG. 1 are provided with portion numbers that are obtained by uniformly adding 100 to the portion numbers shown in FIG. 1.

As a step before the final step (G), although it is not depicted, a heat treatment in which the base 101 is heated for about 60 minutes in an atmosphere of 140°C so as to perform the stress relaxation of the undercoat plating and remove moisture. Next, in the step (G), an electro copper plating layer 104 is laminated on an electroless copper plating layer 103. As the formation of the electro copper plating layer 104, a known means can be used, and for example, a bath composition of CuSO₄·5H₂O (75 g)/liter of water, H₂SO₄ (190 g)/liter of water, Cl (60 ppm) and additives (suitable amounts) is used, phosphorus-containing copper is used as a cathode material, the bath temperature is adjusted to 25°C, and the anode current density is adjusted to 2.5 A/dm2.

### Example 1

An aromatic-based polyamide (6T nylon) (for example, "#NM114HW", a product of Otsuka Chemical Co., Ltd.) in which titanium oxide and potassium titanate whiskers had been mixed as fillers was injection-molded to form a block-shaped base 1. Next, a circuit forming portion 11 of the base 1 was selectively irradiated with a laser beam 2 to modify and roughen the surface. As the laser beam 2, a second higher harmonic wave having a wavelength of 532 nm was used, and scanning was performed only one time after adjusting the output to 95% of 6 W, the scan speed by a galvanometer mirror to 500 mm/second and the pulse frequency to 40 KHz. By doing so, it was confirmed that the surface can be roughened to degree of roughness of 84 µm by a ten-point average.

Next, the base 1 was washed with an alkali to further activate the surface. Here, the alkali washing was performed by, for example, soaking the base 1 for 5 minutes in an aqueous solution of sodium hydroxide having a concentration of 50 g/liter at a temperature of 50°C. The activation was performed by soaking the base 1 for 5 minutes in an aqueous solution obtained by diluting a surfactant (for example, "PB-119S", a product of Ebara-Udylite Co., Ltd.) to 50 cc/liter and setting temperature to 25°C. Next, an ion catalyst liquid was obtained by diluting a palladium ion catalyst (for example, "#ACT-S", a product of Ebara-Udylite Co. , Ltd.) to an ion concentration of 50 ppm by an aqueous solution of hydrochloric acid having a concentration of 0.06% (pH 2.0) and setting the temperature to 25°C, and the activated base 1 was soaked therein for 2 minutes.

Next, the base 1 was soaked in an aqueous solution of sodium borohydrate having a temperature of 25°C and a concentration of 1.5 g/liter, whereby the adsorbed palladium ion catalyst was reduced to palladium metal. At that time, it was confirmed that the palladium metal was not fixed on a non-circuit forming portion 12 wherein the portion had not been roughened by the laser beam. In addition, the base 1 on which the palladium metal had been adsorbed was subjected to an activation treatment by using the surfactant mentioned above.

Next, the base 1 was soaked in an electroless copper plating liquid to precipitate a copper metal by using the palladium metal that had been adsorbed as nuclei, whereby an electroless copper plating layer 3 was formed on the circuit forming portion 11. Namely, the base 1 is soaked for about 15 minutes in an electroless copper plating liquid (for example, "AISL-520", a product of Ebara-Udylite Co., Ltd.) whose liquid temperature has been set to 50°C. Finally, the base 1 was subjected to a heat treatment in an atmosphere of 175°C for 60 minutes to sufficiently attach the electroless plating layer 3 to the roughened surface.

The electroless copper plating layer 3 had a thickness of from 0.5 to 0.6 µ, and the electroless copper plating layer had an adhesion strength of 1.10 N/mm (the adhesiveness test of the plating: conducted according to JISH8504). Meanwhile, the residue of the electroless copper plating, and the like could not be found on the non-circuit forming portion.

### Example 2

An aromatic-based liquid crystal polymer (for example, "Vectra#C820", a product of Polyplastics Co., Ltd.) in which calcium pyrophosphate had been mixed by 50% by weight as a filler was injection-molded to form a block-shaped base 1. Next, a circuit forming portion 11 of the base 1 was selectively irradiated with a laser beam 2 to modify and roughen the surface. As the laser beam 2, a second higher harmonic wave having a wavelength of 532 nm was used, and scanning was performed only one time after adjusting the output to 95% of 6 W, the scan speed by a galvanometer mirror to 1,000 mm/second and the pulse frequency to 40 KHz. By doing so, it was confirmed that the surface can be roughened to degree of roughness of 115 µm by a ten-point average.

Next, the base 1 was washed with an alkali by a means similar to that of Example 1 to activate the surface, and a palladium ion catalyst was adsorbed and reduced to palladium metal. At that time, it was confirmed that the palladium metal was not fixed on the non-circuit forming portion 12. In addition, the base 1 on which the palladium metal had been adsorbed was subjected to an activation treatment by using a similar surfactant to that in Example 1. Next, an electroless copper plating layer 3 was formed on the circuit forming portion 11 of the base 1 according to similar procedures to those of Example 1. Finally, the base 1 was subjected to a heat treatment in an atmosphere of 175°C for 60 minutes in a similar manner to that of Example 1 to sufficiently attach the electroless plating layer 3 to the roughened surface.

The electroless copper plating layer 3 had a thickness of from 0.5 to 0.6 µ, and the electroless copper plating layer had an adhesion strength of 0.8 N/mm (the adhesiveness test of the plating: conducted according to JISH8504). Meanwhile, the residue of the electroless copper plating, and the like could not be found on the non-circuit forming portion.

### Example 3

An aromatic-based liquid crystal polymer ("Zi-ma inus #3W Reflow", a product of Sumitomo Osaka Cement Co., Ltd.) to which alumina oxide had been added as a filler was injection-molded to form a block-like base 1. Next, a circuit forming portion 11 of the base 1 was selectively irradiated with a laser beam 2 similar to that of Example 2 to modify and roughen the surface. By doing so, it was confirmed that the degree of roughness of the surface can be 306 µm by a ten-point average.

Next, the base 1 was washed with an alkali by a means similar to that of Example 1 to activate the surface, and a palladium ion catalyst was adsorbed and thereafter reduced to palladium metal. At that time, it was confirmed that the palladium metal is not fixed on a non-circuit forming portion 12. In addition, the base 1 on which the palladium metal had been adsorbed was subjected to an activation treatment by using a similar surfactant to that in Example 1. Next, an electroless copper plating layer 3 was formed on the circuit forming portion 11 of the base 1 according to similar procedures to those of Example 1. Finally, the base 1 was subjected to a heat treatment in an atmosphere of 175°C for 60 minutes in a similar manner to that of Example 1 to sufficiently attach the electroless plating layer 3 to the roughened surface.

The electroless copper plating layer 3 had a thickness of from 0.5 to 0.6 µ, and the electroless copper plating layer had an adhesion strength of 0.8 N/mm (the adhesiveness test of the plating: conducted according to JISH8504) . Meanwhile, the residue of the electroless copper plating, and the like could not be found on the non-circuit forming portion.

### Example 4

Polycarbonate/ABS ("#S3100", a product of Daicel Polymer Ltd.) was injection-molded to form a block-like base 1. Next, a circuit forming portion 11 of the base 1 was selectively irradiated with a laser beam 2 similar to that of Example 2 to modify and roughen the surface. By doing so, it was confirmed that the degree of roughness of the surface can be 126 µm by a ten-point average.

The base 1 was then subjected to a similar treatment to that of Example 1 to form an electroless copper plating layer 3 on the circuit forming portion 11. The treatment is different from that of Example 1 in that the ion concentration of the palladium ion catalyst was adjusted to be relatively high as 180 ppm, the ion catalyst liquid was adjusted to 25°C, and the base 1 was soaked for a relatively long time as 10 minutes. Finally, the base 1 was subjected to a heat treatment in an atmosphere of 175°C for 60 minutes in a similar manner to that of Example 1 to sufficiently attach the electroless plating layer 3 to the roughened surface.

The electroless copper plating layer 3 had a thickness of from 0.5 to 0.6 µ, and the electroless copper plating layer had an adhesion strength of 1.5 N/mm (the adhesiveness test of the plating: conducted according to JISH8504) . Meanwhile, the residue of the electroless copper plating, and the like could not be found on the non-circuit forming portion.

### Example 5

An aromatic-based nylon ("#TA112", a product of Kuraray Co., Ltd.) was injection-molded to form a block-like base 1. Next, a circuit forming portion 11 of the base 1 was selectively irradiated with a similar laser beam 2 to that of Example 2 to modify and roughen the surface. Meanwhile, the laser beam used was different from that of Example 2 in that the output was set to relatively low as 85% of 6 W and the pulse frequency was set to relatively high as 60 KHz. By doing so, it was confirmed that the degree of roughness of the surface can be 91 µm by a ten-point average.

Next, a base 1 was treated in a similar manner to that of Example 1 to form an electroless copper plating layer 3 on the circuit forming portion 11. Meanwhile, the treatment was different from that of Example 1 in that the ion concentration of the palladium ion catalyst was adjusted to be relatively high as 180 ppm. Finally, the base 1 was subjected to a heat treatment in an atmosphere of 175°C for 60 minutes in a similar manner to that of Example 1 to sufficiently attach the electroless plating layer 3 to the roughened surface.

The electroless copper plating layer 3 had a thickness of from 0.5 to 0.6 µ, and the electroless copper plating layer had an adhesion strength of 1.5 N/mm (the adhesiveness test of the plating: conducted according to JISH8504) . Meanwhile, the residue of the electroless copper plating, and the like could not be found on the non-circuit forming portion.

### Example 6

In the above-mentioned Examples 1 to 5, the ion concentrations of the palladium ion catalyst are only two points of 50 ppm and 180 ppm. Therefore, we have investigated the formation of the electroless plating in the cases when the ion concentrations of the palladium ion catalyst were 5, 10, 50 and 100 ppm, respectively. In addition, we have also investigated the formation of the electroless plating in the case when a conventional colloid catalyst was used.

In a similar manner to that of Example 1, an aromatic-based polyamide (6T nylon) ("#NM114HW", a product of Otsuka Chemical Co., Ltd.) in which titanium oxide and potassium titanate whiskers had been mixed as fillers was injection-molded to form a block-shaped base 1, and a circuit forming portion 11 of the base 1 was selectively irradiated with a laser beam 2 to modify and roughen the surface. The laser beam 2 was irradiated also in a similar manner to that of Example 1.

Next, in a manner similar to Example 1, the base 1 was washed with an alkali to further activate the surface. Next, a palladium ion catalyst ("#ACT-S", a product of Ebara-Udylite Co., Ltd.) was diluted to ion concentrations of 5, 10, 50 and 100 ppm, respectively, by an aqueous solution of hydrochloric acid having a concentration of 0.06% (pH 2.0) and the temperature was adjusted to 25°C to give ion catalyst liquids, and the activated base 1 was soaked in each of these ion catalyst liquids for 2 minutes.

Next, in a manner similar to Example 1, the palladium ion catalyst that had been adsorbed on the base 1 was then reduced to palladium metal, and the base 1 on which the palladium metal had been adsorbed was subjected to an activation treatment by using a surfactant. Next, the base 1 was soaked in a similar electroless copper plating liquid to that of Example 1, and the state of formation of the electroless copper plating layer was checked for the surface that had been irradiated with the laser beam 2 (hereinafter referred to as "irradiated surface") and the surface that had not been irradiated with the laser beam 2 (hereinafter referred to as "non-irradiated surface"). In addition, for comparison, a conventional colloid catalyst was provided to the base 1 whose surface had been activated by the above-mentioned alkali washing, the base 1 was soaked in a similar electroless copper plating liquid to that of Example 1, and the state of formation of the electroless copper plating layer was checked for the irradiated surface and non-irradiated surface. The results of these tests were as follows.

In the case when the ion concentration of the palladium ion catalyst was 5 ppm, precipitation of the electroless copper plating on the irradiated surface was insufficient, and thus the conductivity could not be measured by a conductivity test. In the case when the ion concentration was 10 ppm, an electroless copper plating layer was formed on the irradiated surface and had sufficient conductivity. Meanwhile, formation of an electroless copper plating layer could not be confirmed visually on the non-irradiated surface. In the cases when the ion concentrations were 50 and 100 ppm, respectively, something looked like an electroless copper plating layer was slightly confirmed visually on the non-irradiated surface, but the layer had an insulating resistance value of about 10¹⁴ Ω in both cases, therefore the value was sufficient for the insulating property between electroconductive circuits. In the case when the conventional colloid catalyst was provided, formation of an electroless copper plating layer was confirmed on not only the irradiated surface but also on the non-irradiated surface.

### Example 7

An investigation was executed when the acidic ion catalyst used in the above-mentioned Example 1 was changed to an alkaline ion catalyst. Other conditions were similar to those of the above-mentioned Example 1. Namely, "#Neogant 834", a product of Atotech Japan K. K., was diluted to an ion concentration of 50 ppm by an aqueous solution of caustic soda (pH 10.5), the temperature was set to 40°C, and the above-mentioned activated base 1 was soaked for 5 minutes. An electroless copper plating layer 3 had a thickness of from 0.5 to 0.6 µ, and the electroless copper plating layer had an adhesion strength of 1. 10 N/mm (the adhesiveness test of the plating: conducted according to JISH8504). Meanwhile, the residue of the electroless copper plating, and the like could not be found on the non-circuit forming portion.

### Example 8

An investigation was carried out when the acidic ion catalyst used in the above-mentioned Example 2 was changed to the alkaline ion catalyst used in Example 7. Other conditions were similar to those of the above-mentioned Example 2. The electroless copper plating layer 3 had a thickness of from 0.5 to 0 . 6 µ, and the electroless copper plating layer had an adhesion strength of 0.6 N/mm (the adhesiveness test of the plating: conducted according to JISH8504). Meanwhile, the residue of the electroless copper plating, and the like could not be found on the non-circuit forming portion.

### Example 9

An investigation was carried out when the acidic ion catalyst used in the above-mentioned Example 3 was changed to the alkaline ion catalyst used in Example 7. Other conditions were similar to those of the above-mentioned Example 3. The electroless copper plating layer 3 had a thickness of from 0.5 to 0.6 µ, and the electroless copper plating layer had an adhesion strength of 0.6 N/mm (the adhesiveness test of the plating: conducted according to JISH8504). Meanwhile, the residue of the electroless copper plating, and the like could not be found on the non-circuit forming portion.

### Example 10

An investigation was carried out when the acidic ion catalyst used in the above-mentioned Example 4 was changed to the alkaline ion catalyst used in Example 7. Other conditions were similar to those of the above-mentioned Example 4. An electroless copper plating layer 3 had a thickness of from 0.5 to 0.6 µ, and the electroless copper plating layer had an adhesion strength of 1.4 N/mm (the adhesiveness test of the plating: conducted according to JISH8504). Meanwhile, the residue of the electroless copper plating, and the like could not be found on the non-circuit forming portion.

### Example 11

An investigation was carried out when the acidic ion catalyst used in the above-mentioned Example 5 was changed to the alkaline ion catalyst used in Example 7. Other conditions were similar to those of the above-mentioned Example 5. An electroless copper plating layer 3 had a thickness of from 0.5 to 0.6 µ, and the electroless copper plating layer had an adhesion strength of 1.4 N/mm (the adhesiveness test of the plating: conducted according to JISH8504). Meanwhile, the residue of the electroless copper plating, and the like could not be found on the non-circuit forming portion.

### Example 12

In the above-mentioned Examples 7 to 11, the ion concentrations of the alkaline palladium ion catalyst are only two points of 50 ppm and 180 ppm. Therefore, we have investigated the formation of the electroless plating in the cases when the ion concentrations of the alkaline palladium ion catalyst were 5, 10, 50 and 100 ppm, respectively. In addition, we have also investigated the formation of the electroless plating in the case when a conventional colloid catalyst was used.

Namely, an investigation was carried out when the aqueous solution of the acidic ion catalyst used in the above-mentioned Example 6 was changed to a dilution of a palladium ion catalyst ("#Neogant 834", a product of Atotech Japan K. K.) in an aqueous solution of caustic soda (pH 10.5). Other conditions were similar to those of the above-mentioned Example 6. The state of formation of the electroless copper plating layer in such case was as follows.

In the case when the ion concentration of the alkaline palladium ion catalyst was 5 ppm, precipitation of the electroless copper plating on the irradiated surface was insufficient, and thus the conductivity could not be measured by a conductivity test. In the case when the ion concentration was 10 ppm, an electroless copper plating layer was formed on the irradiated surface, and the layer had sufficient conductivity. Meanwhile, formation of an electroless copper plating layer cannot be confirmed visually on the non-irradiated surface. In the cases when the ion concentrations were 50 and 100 ppm, respectively, something looked like an electroless copper plating layer was slightly confirmed visually on the non-irradiated surface, but the layer had an insulating resistance value of about 10¹⁴ Ω in both cases, therefore the value was sufficient for the insulating property between electroconductive circuits. Meanwhile, in the case when the conventional colloid catalyst was provided, formation of an electroless copper plating layer was confirmed on not only the irradiated surface but also on the non-irradiated surface.

### Industrial Applicability

Since an electroless plating layer can be selectively formed only on a circuit forming portion wherein the portion has been irradiated with a laser beam, the present invention can be widely utilized in industries relating to electronic devices and the like.

## Claims

1. A method for producing a formed circuit component, comprising:
a first step of forming a base (1) of a synthetic resin,
a second step of irradiating a circuit forming portion (11) of the base with a laser beam (2) having a wavelength of from 405 to 1,064 nm to selectively roughen and surface-modify the portion,
a third step of contacting the base with an ion catalyst composed of one kind of metal ion,
a fourth step of reducing the ion catalyst to a metal by a reducing agent, and
a fifth step of forming an electroless plating layer (3) on the circuit forming portion (11) of the base.

2. The method for producing a formed circuit component according to claim 1, wherein an ion concentration of the ion catalyst is diluted to from 10 to 180 ppm by an acid aqueous solution.

3. The method for producing a formed circuit component according to claim 1, wherein an ion concentration of the ion catalyst is diluted to from 10 to 180 ppm by an alkaline aqueous solution.

4. The method for producing a formed circuit component according to any of claims 1 to 3, which comprises a sixth step of removing the residue of the electroless plating formed during an initial stage of a precipitation reaction on a non-circuit forming portion of the base by using a reagent.

5. The method for producing a formed circuit component according to any of claims 1 to 4, wherein a selectively roughened surface of the circuit forming portion (11) has an average roughness of at least 1 µm.

6. The method for producing a formed circuit component according to any of claims 1 to 5, wherein the reducing agent is an aqueous solution selected from a group consisting of sodium borohydrate, dimethylamineborane, hydrazine, sodium hypophosphite and formaldehyde with a content rate of from 0.01 to 100 g/liter.

7. The method for producing a formed circuit component according to any of claims 1 to 6, wherein a second metal layer (104) is formed on the surface of the electroless plating layer (103) of the circuit forming portion (11).

8. The method for producing a formed circuit component according to any of claims 1 to 7, wherein the synthetic resin is an aromatic-based liquid crystal, and an aromatic-based polyamide polymer selected from a group consisting of 10T nylon, 9T nylon, 6T nylon, 4T nylon and polyphthalamide (PPA), and
the synthetic resin contains a filler selected from a group consisting of titanium oxide, potassium titanate, zinc oxide, talc, glass fiber, calcium pyrophosphate and alumina oxide.

## Patentansprüche

1. Verfahren zum Herstellen einer geformten Schaltungskomponente, umfassend:
einen ersten Schritt des Bildens einer Basis (1) eines synthetischen Harzes,
einen zweiten Schritt des Bestrahlens eines Schaltungsbildungsabschnitts (11) der Basis mit einem Laserstrahl (2), der eine Wellenlänge von 405 bis 1064 nm aufweist, um den Abschnitt selektiv aufzurauen und dessen Oberfläche zu ändern,
einen dritten Schritt des Inkontaktbringens der Basis mit einem Ionenkatalysator, der aus einer Art von Metallion besteht,
einen vierten Schritt des Reduzierens des Ionenkatalysators zu einem Metall durch ein Reduktionsmittel und
einen fünften Schritt des Bildens einer stromlosen Plattierungsschicht (3) auf dem Schaltungsbildungsabschnitt (11) der Basis.

2. Verfahren zum Herstellen einer geformten Schaltungskomponente nach Anspruch 1, wobei eine Ionenkonzentration des Ionenkatalysators auf von 10 bis 180 ppm durch eine saure wässrige Lösung verdünnt wird.

3. Verfahren zum Herstellen einer geformten Schaltungskomponente nach Anspruch 1, wobei eine Ionenkonzentration des Ionenkatalysators auf von 10 bis 180 ppm durch eine alkalische wässrige Lösung verdünnt wird.

4. Verfahren zum Herstellen einer geformten Schaltungskomponente nach einem der Ansprüche 1 bis 3, das einen sechsten Schritt des Entfernens des Rests der stromlosen Plattierung umfasst, die während einer Anfangsphase einer Fällungsreaktion auf einem Nicht-Schaltungsbildungsabschnitt der Basis durch Verwenden eines Reagens gebildet wird.

5. Verfahren zum Herstellen einer geformten Schaltungskomponente nach einem der Ansprüche 1 bis 4, wobei eine selektiv aufgeraute Oberfläche des Schaltungsbildungsabschnitts (11) eine mittlere Rauheit von mindestens 1 µm aufweist.

6. Verfahren zum Herstellen einer geformten Schaltungskomponente nach einem der Ansprüche 1 bis 5, wobei das Reduktionsmittel eine wässrige Lösung ist, die ausgewählt ist aus einer Gruppe bestehend aus Natriumborhydrat, Dimethylaminboran, Hydrazin, Natriumhypophosphit und Formaldehyd mit einem Gehalt von 0,01 bis 100 g/Liter.

7. Verfahren zum Herstellen einer geformten Schaltungskomponente nach einem der Ansprüche 1 bis 6, wobei eine zweite Metallschicht (104) auf der Oberfläche der stromlosen Plattierungsschicht (103) des Schaltungsbildungsabschnitts (11) gebildet wird.

8. Verfahren zum Herstellen einer geformten Schaltungskomponente nach einem der Ansprüche 1 bis 7, wobei das synthetische Harz ein Flüssigkristall auf aromatischer Basis und ein Polyamidpolymer auf aromatischer Basis ist, das ausgewählt ist aus einer Gruppe bestehend aus Nylon 10T, Nylon 9T, Nylon 6T, Nylon 4T und Polyphthalamid (PPA), und
das synthetische Harz einen Füllstoff enthält, der ausgewählt ist aus einer Gruppe bestehend aus Titanoxid, Kaliumtitanat, Zinkoxid, Talk, Glasfaser, Calciumpyrophosphat und Tonerde-Oxid.

## Revendications

1. Procédé de production d'un composant de circuit à forme, comprenant :
une première étape de formation d'une base (1) d'une résine synthétique,
une deuxième étape d'irradiation d'une partie formant un circuit (11) de la base avec un faisceau laser (2) présentant une longueur d'onde allant de 405 à 1064 nm pour rendre rugueuse de manière sélective la partie et modifier la surface de celle-ci,
une troisième étape de mise en contact de la base avec un catalyseur d'ion composé d'une sorte d'ion métallique,
une quatrième étape de réduction du catalyseur d'ion en un métal par un agent réducteur, et
une cinquième étape de formation d'une couche à placage autocatalytique (3) sur la partie formant un circuit (11) de la base.

2. Procédé de production d'un composant de circuit à forme selon la revendication 1, dans lequel une concentration ionique du catalyseur d'ion est diluée de 10 à 180 ppm par une solution aqueuse acide.

3. Procédé de production d'un composant de circuit à forme selon la revendication 1, dans lequel une concentration ionique du catalyseur d'ion est diluée de 10 à 180 ppm par une solution aqueuse alcaline.

4. Procédé de production d'un composant de circuit à forme selon l'une quelconque des revendications 1 à 3, qui comprend une sixième étape de retrait du résidu du placage autocatalytique formé pendant un stade initial d'une réaction de précipitation sur une partie qui ne forme pas de circuit de la base à l'aide d'un réactif.

5. Procédé de production d'un composant de circuit à forme selon l'une quelconque des revendications 1 à 4, dans lequel une surface rendue rugueuse de manière sélective de la partie formant un circuit (11) présente une rugosité moyenne d'au moins 1 µm.

6. Procédé de production d'un composant de circuit à forme selon l'une quelconque des revendications 1 à 5, dans lequel l'agent réducteur est une solution aqueuse choisie dans un groupe constitué par le borohydrure de sodium, le diméthylamineborane, l'hydrazine, l'hypophosphite de sodium et le formaldéhyde avec un taux en teneur allant de 0,01 à 100 g/litre.

7. Procédé de production d'un composant de circuit à forme selon l'une quelconque des revendications 1 à 6, dans lequel une deuxième couche métallique (104) est formée sur la surface de la couche à placage autocatalytique (103) de la partie formant un circuit (11).

8. Procédé de production d'un composant de circuit à forme selon l'une quelconque des revendications 1 à 7, dans lequel la résine synthétique est un cristal liquide à base aromatique et un polymère de polyamide à base aromatique choisi dans un groupe constitué par nylon 10T, nylon 9T, nylon 6T, nylon 4T et le polyphthalamide (PPA), et
la résine synthétique contient une charge choisie dans un groupe constitué par l'oxyde de titane, le titanate de potassium , l'oxyde de zinc, le talc, la fibre de verre, le pyrophosphate de calcium et l'oxyde d'alumine.
